# EUROPEAN PATENT APPLICATION

(11) **EP 3 846 222 A1**
(43) Date of publication of application: **07.07.2021**
(21) Application number: 19854146.8
(22) Date of filing: 29.08.2019
(51) Int. Cl.: H01L 29/772, H01L 21/02, H01L 21/70, H01L 23/552

(54) **JUNCTION FIELD-EFFECT TRANSISTOR, METHOD FOR OBTAINING SAME AND USE THEREOF**

(30) Priority: 31.08.2018 ES 201830860
(71) Applicant: Consejo Superior De Investigaciones Científicas, 28006 Madrid (ES)
(72) Inventor: ULLÁN COMES, Miguel, 08193 Cerdanyola del Vallès (Barcelona) (ES); COUSO FONTANILLO, Carlos, 08193 Cerdanyola del Vallès (Barcelona) (ES); HIDALGO VILLENA, Salvador, 08193 Cerdanyola del Vallès (Barcelona) (ES); FLORES GUAL, David, 08193 Cerdanyola del Vallès (Barcelona) (ES); QUIRION, David, 08193 Cerdanyola del Vallès (Barcelona) (ES)
(74) Representative: Pons
(86) International application number: PCT/ES2019/070578
(87) International publication number: WO 2020/043927

(57) **Abstract**

This document describes both a junction field effect-transistor (JFET) device, which is the subject of a first aspect of the invention, and the method for obtaining same, which is the subject of a second aspect of the invention. The junction field-effect transistor (JFET) device has a series of concentric circular trenches that are protected by one or more protective trenches. Said protective trenches are rectangular with rounded corners and are split into floating protective trenches and polarised protective trenches, such that one polarised protective trench is located outside the last concentric trench while one floating protective trench is located outside said polarised protective trench.

## Description

### OBJECT OF THE INVENTION

The object of the invention falls within the field of semiconductor devices and the manufacturing processes thereof.

More specifically, the object of the invention relates to a JFET-type transistor device and a method for obtaining same.

### BACKGROUND OF THE INVENTION

The JFET (Junction Field-Effect Transistor) is a type of electronic device with three terminals S (Source), G (Gate) and D (Drain), the operation of which as an electronic switch is based on the electric field effect that is produced by the difference in voltage applied between the terminals S and G, V_{GS}. According to this input value V_{GS}, the output of the JFET-type transistor will have a behaviour that is simplified by defining two regions: active (on) and cut-off (off). The different values of I_{DS} depending on the V_{GS} are given by a graph or equation called the input equation.

In the active region, which allows the current to pass through, the transistor will give an output in the circuit that is defined by the drain current (I_{DS}) itself and the voltage between the drain and the source V_{DS}. The graph or equation that relates these two variables is called the output equation, and it is therein that the three operating regions are distinguished: ohmic, triode and saturation.

Physically, a so-called "P-channel" JFET-type transistor is formed by a P-type semiconductor substrate, at the ends of which two output terminals (drain and source) are located flanked by two regions with N-type doping in which the terminals connected to each other (gate) are connected. When applying a positive voltage V_{GS} between gate and source, (PN junction) a carrier emptying region is created in the channel (region flanked by the gate electrodes) reducing the current flow between the source and the drain (I_{DS}). When this V_{GS} exceeds a certain value, the channel is completely empty of carriers and the current I_{DS} between source and drain is negligible. That V_{GS} value is called the cut-off voltage (V_{off}). For an "N-channel" JFET the P and N regions are reversed, and the V_{GS} and V_{off} are negative, cutting the current off for voltages less than V_{off} (negative).

Devices of this type are known, along with those methods for obtaining same. In this sense, various documents are known such as US8068321B2 which describes a conventional JFET for surge protection (protection against unwanted voltage spikes) of a low voltage DC/DC converter. However, the device works as a normally-off switch that is only activated when it has to protect the main system by withstanding the unwanted current and wherein the conduction is based on electrons and the technology is based on an initial N⁺ substrate on which a thin N⁻ epitaxial layer is grown. Next, implants are carried out to create the gate (boron) and the source (phosphorus).

Also, document US6251716B1 describes a JFET with low resistance and high switching speed in high current devices (100 A in large area chips). However, the capacity in voltage is limited by the thickness of the N-epitaxial layer. Furthermore, the aforementioned high switching speed cannot be achieved if a high voltage capacity is required and the conduction is based on electrons and the technology is based on an initial N+ substrate, on which a thin N- epitaxial layer is grown, to then create the multiple gates (boron) and the drain region (phosphorus).

Document US6380569B1 describes a conventional high-power, high-voltage JFET device, although it operates as a "normally-off" device and based on conventional N⁺/N⁻ substrates. In addition, a trench, which includes a gate oxide and the necessary conductive filler material, controls the JFET region. In fact, it has P-type diffusions at the lower portion of the trench to prevent premature breakdown. The device is aimed at power applications, wherein the switching speed is not crucial but wherein a high current capacity is required. Furthermore, document US20090075435A1 describes a JFET device that is based on the use of an insulating region created in the substrate, in an area close to the surface thereof. It is essentially an SOI JFET and, as a result, the source, drain, and gate electrodes have to be placed on the same side of the substrate, resulting in a low voltage. The process technologies described in US20090075435A1 are based on the insulating layer and differ from each other in the way the top semiconductor and doped layer is created. In all cases, a shallow trench is created and filled with polysilicon; the cross section of the JFET proposed in US20090075435A1 is based on electron currents and the topology thereof is such that the JFET proposed in US20090075435A1 provides an extremely fast and low parasitic switching speed; in other words, it is designed for high frequency and low voltage applications.

In view of the above, the JFET devices found in the state of the art are widely used as switches or as passive protective element. However, none of them are valid for high radiation applications, since manufacturing them requires the use of an inter-level oxide that fails under exposure to ionising radiation. Furthermore, although the use of N-type substrates in electronic devices improves some of the electrical performances thereof, it makes them more vulnerable to the effects of radiation, and therefore unable to operate in environments with a high radiation presence. Thus, one of the relevant lines of research in modern power electronics is the search for devices suitable for power distribution circuits and system control which are capable of operating in high radiation environments.

Document P201531371 describes a vertical JFET device, in which the current flows from the upper portion of the chip (source) to the lower portion (drain), passing through the entire silicon block, as well as a method for manufacturing said JFET device by means of DRIE (Deep reactive-ion etching). This document describes a series of deep blind trenches in a block of P-type semiconductor material. These trenches are then filled with a layer of N-type conductive material, said trenches being preferably configured with a circular or polygonal cross section defining a body that encloses a volume of the P-type semiconductor block; in other words, seen in plan view, the polygon or circle defined on the surface of the block by the walls of the trench is made of a P-type material, while the trench must be filled with an N-type conductive material. The trench acts as gate of the transistor device, while the semiconductor portion of the block enclosed between the walls of the trench (the aforementioned circles or polygons seen in plan view) will be the intrinsic active portion of the JFET transistor, called the channel. However, due to the design thereof, the breakdown voltage in cut-off mode does not exceed 300 V. This voltage is too low for certain applications, wherein values up to 1000 V are necessary for the proper operation of the sensors. It is known that the voltage limitation (maximum breakdown voltage) of the V-JFET is intrinsic to the design thereof, due to the small radius of curvature of the basic cell (<35 microns). The breakdown is produced in the cells with a smaller radius, since when there is a voltage difference, the electric field increases rapidly therein until the silicon breaks 3·10⁵ V/cm. This can be avoided by increasing the radius of the basic cell; however, this radius cannot simply be increased, since some of the electrical performances of the device would be abruptly degraded, such as: the cut-off voltage (Voff), the cut-off current (I_{off}) or the saturation current (Isat). Moreover, the current carrying capacity of each cell in the device described in P201531371 is quite limited (0.3 A/cm²), which implies having to make devices with excessively large areas (>1 cm²) in order to make up for this lack, incompatible with conventional power encapsulations for discrete devices.

### DESCRIPTION OF THE INVENTION

In a first aspect of the invention, there is a JFET device with multiple concentric rings, while in a second aspect of the invention, there is a method for manufacturing the JFET device of the first aspect; method that preferably makes use of the DRIE (Deep reactive-ion etching) processing technique.

The transistor object of a first aspect of the invention has a succession of concentric rings (multi-ring), wherein the distance between consecutive rings is small enough to keep the electrical features of a JFET device intact and that the trench of each ring protects the inner adjacent ring from electrical breakdown. In this way, the only ring that must be protected against electrical breakdown will be the outermost ring of all of them, which can be designed with an arbitrarily large radius of curvature (depending only on the number of concentric rings that are included). The outer rings of each cell are protected with three-dimensional elements, unlike the prior art (P201531371), wherein the termination of the V-JFET device is manufactured only with 2D elements (guard rings and surface implantations) which prove to be insufficient for effective cell edge protection. The three-dimensional protective elements used in the present invention are called guard trenches, which can be polarised or floating depending on the requirements of the embodiment. The guard trench protection system can be implemented in the following way: a first protective or guard ring is polarised at the same voltage as the trenches of the MR-JFET devices, generating a transition from the outer ring of the MR- JFET (with dimensions greater than 150 µm) to a polarised linear ring of infinite radius (straight line) and minimising chances of breakdown. From this polarised linear ring, consecutive and parallel floating rings are generated, causing the electric field at the bottom of the trenches to reduce smoothly and progressively, as if they were 2D guard rings.

Additionally, this transition that has just been explained can be carried out in a more progressive way, introducing more polarised rings between the transition of the outer ring until reaching the linear form.

Another advantage of arranging concentric rings is that the deep trenches can be etched while maintaining mechanical stability, since these trenches do not coincide with the crystallographic planes of the silicon in any case.

Therefore, the use of the "multi-ring" arrangement provides great advantages over the prior art, for example:
- The obvious increase in the radius of curvature of the outer ring, which increases the breakdown voltage of the device.
- Since cells can be designed in different sizes, by varying the number of rings, a greater area of the silicon can be used. This increases the current capacity of the device. Likewise, it is possible to arrange one cell (several concentric rings) or several cells (several groupings of concentric rings) within the same protective trenches.
- The source contacts, which are placed in the centre between every two consecutive rings (channels), have a greater area, and therefore, the injection of electrons into the channel increases, increasing the current capacity thereof.

The transistor of the object of the invention can operate as a resistor the size of the intrinsic conduction volume (channel or channels) in situations wherein it is in the linear region, this resistor can be close to zero at low input voltages or low source-drain polarisation. In these situations, the source-drain polarisation is increased in such a way that there is an increase in voltage in the channel. The lower portion of the channel is progressively emptied until a "choke" voltage is reached wherein the lower portion of the channel is completely emptied and the current is saturated. Furthermore, if the gate voltage is increased, reversing the PN junction formed with the internal semiconductor and the gate of the device, the channel becomes increasingly impoverished, until it is totally empty at a value of *V_{off}* in particular, and consequently, there is no current conduction in the channel.

In an embodiment of the first aspect of the invention, the channel of the transistor object of the invention is made of P-type silicon, and the trenches are filled with an N-type material such as polysilicon, which can be highly doped. In this way, the device can be used as a radiation resistant power switch in power distribution applications. P-type silicon is not reversed (to N-type) due to the damage caused by the displacement of non-ionising radiation, which makes the substrate more resistant to this type of radiation. Moreover, the only oxides present in the device are on the surface thereof, which makes the device more robust against ionising radiation damage due to the vertical configuration thereof. Additionally, the radius of the intrinsic channel can be reduced until a low cut-off voltage is obtained which enables the use of a low-power control circuit carried out with a sub-micron (DSM) CMOS process, which causes the entire system to be even more resistant to radiation, since DSM processes are intrinsically more resistant to radiation. In this way, the device can be used as a power switch in power distribution applications in environments subject to high radiation.

Among the possible uses of the transistor of the invention or obtainable by the method of the second aspect of the invention is the use as a switch or as a rad-hard switch. Also, it could be used as a normally-on current limiter.

### DESCRIPTION OF THE DRAWINGS

To complement the description that is being made and for the purpose of helping to better understand the features of the invention according to a preferred practical exemplary embodiment thereof, a set of drawings is attached as an integral part of said description in which the following is depicted in an illustrative and non-limiting manner:

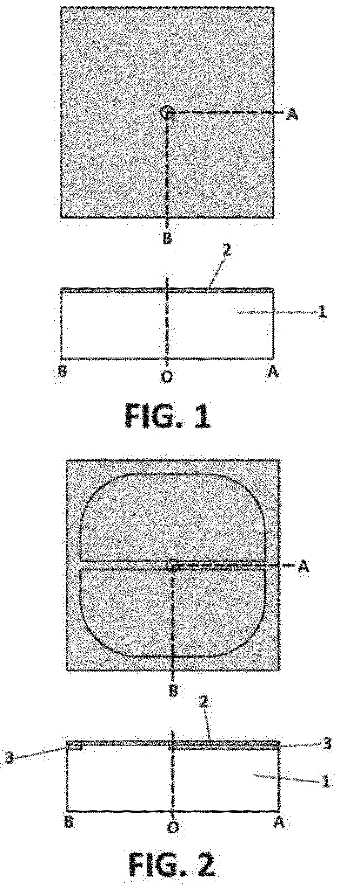

Figures 1-5 show respective plan views and (cross sections) marked by means of dotted lines that show the manufacture of a preferred embodiment of the object of the invention.

### PREFERRED EMBODIMENT OF THE INVENTION

In an exemplary embodiment of the invention, the second aspect thereof related to the method for obtaining the JFET transistor device, also referred to throughout this example as device or simply transistor, begins from the first aspect of the invention, in a preferred embodiment of the invention described herein (Figures 1-5).

In this way, the second aspect of the invention related to the method for obtaining the JFET transistor begins from the first aspect of the invention, as seen in Figure 1. The starting material for the embodiment is preferably a P-type semiconductor block (1); an alternative embodiment can be made with an N-type semiconductor, conveniently changing the rest of the doping. From this block (1), a first dielectric layer (2) is grown, such as silicon oxide, by means of thermal processes to passivate the Si surface.

Next, a pattern is carried out on the first dielectric layer (2) together with a selective implantation of N-type doping elements (3) when the block (1) is a P-type semiconductor and vice versa with P-type dopants when the semiconductor of the block (1) is an N-type semiconductor, to subsequently proceed to a thermal process to form the result that can be seen in Figure 2. Note that the different colours of the filling in the plan view of Figure 2 represent the pattern of the implantation carried out.

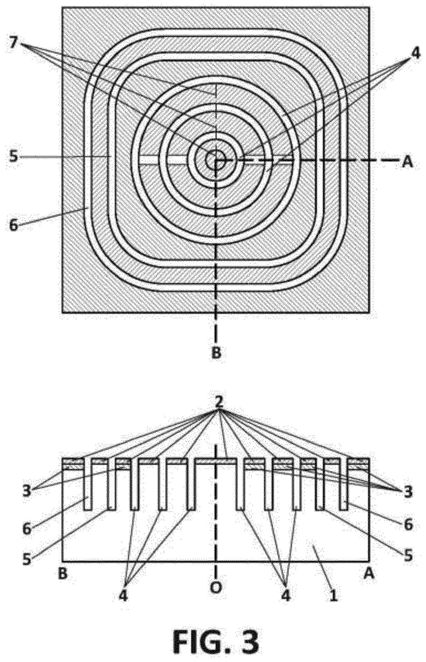

Next, a metal layer is deposited which, once defined according to the corresponding pattern, will act as a selective mask for the subsequent deep silicon etching. Thus, circular concentric crowns are created (blind trenches smaller than 5 microns wide) which will act as gate contacts (4), made in the first dielectric layer (2) and that reaches inside the block (1) of semiconductor material, down to a depth of about 80 microns, as seen in Figure 3. The difference between the smaller radius of a crown and the larger radius of the crown immediately before it is constant throughout the series of crowns, such that successive concentric channels (6) in the shape of a circular crown of semiconductor material of the block (1) are defined in the space between the concentric circular trenches (4).

Additionally, in the same deep silicon etching process, protective trenches (51, 61) are made, the number of which depends on the necessary protection of the particular embodiment, but always with at least one of each, which also are less than 5 microns wide, performed in the first dielectric layer (2) and that reaches inside the block (1) of semiconductor material, to a depth of around 80 microns. These protective trenches (51, 61), preferably with a rectangular or square plan and preferably with rounded corners, around the outermost circular trench (4), at a distance of the order of 20 microns, will serve as guard trenches for the edge of the device. In the preferred embodiment of the second aspect of the invention, the trench (4) located immediately outside the last trench (4) of the cell is polarised at the same voltage as the gate (5). Whereas the subsequent trench (4) remains floating contributing to an increase in the breakdown voltage by smoothing the electric field in the device.

Subsequently, the metal that has served as a mask is etched, removing it completely. Alternatively, a different material, such as silicon oxide, can be used as a mask for deep etching.

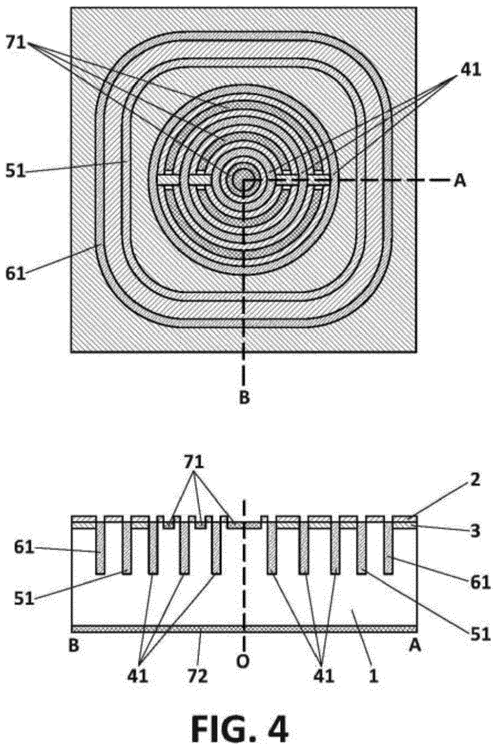

In a preferred embodiment shown in Figure 4, the trench (4) made in the block (1) is filled with conductive doped polysilicon (41), the doping of which is P-type or N-type as necessary depending on the semiconductor type of the block (1), the doping being of the type opposite to that of the semiconductor of the block (1). Subsequently, a thermal process is carried out to extend the P-or N-type dopants from the doped polysilicon towards the walls of the trench, thus defining the different gate contacts (41) of the JFET-type transistor of the invention.

In this same process of filling the trench and subsequent thermal process, the first and second guard rings are also defined, defined by the protective trenches (51, 61) corresponding to a polarised protective trench (51) and to a floating protective trench (61), such that there is at least one polarised protective trench (51) performed in the dielectric layer (2) and that reaches inside the block (1) of semiconductor material and is located outside the concentric series of trenches (4) and at least one floating protective trench (61) performed in the dielectric layer (2) and that reaches inside the block (1) of semiconductor material and is located outside the polarised protective trench (51) and preferably coinciding at least partially with the edge of the transistor.

Then a selective etching process of the first dielectric layer (2) is carried out in a specific region in the centre of the channels (6), to carry out a selective implantation of P- or N-type doping elements as necessary, of the same type as the semiconductor of the block (1), only in the regions wherein the first dielectric layer (2) has been etched, i.e., the silicon oxide, to later carry out a thermal process to form the result that can be seen in Figure 4, defining the source contacts (71) of the transistor.

Next, a process of selective implementation of P- or N-doping elements is carried out as necessary, of the same type as the semiconductor of the block (1), on the back of the block (1) to later carry out a thermal process to form the result that can be seen in Figure 4, defining the drain contacts (72) of the transistor.

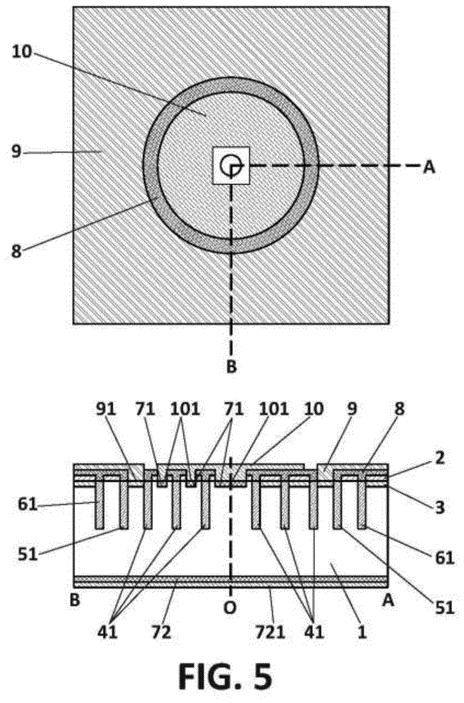

Next, a growth or, alternatively a deposit, of a second dielectric layer (8) that can be silicon oxide is carried out, by means of thermal processes to act as an insulating layer between conductive layers. Next, selective etching of this second dielectric layer (8) is carried out in specific regions for the opening of respective contact windows (91, 101) for the gate (4) and the protective trench (51) and for the source (10) of the transistor, as seen in Figure 5.

Alternatively, in those embodiments wherein the block (1) is of an N-type semiconductor, the doping of the conductor (41) that defines the gate (4) will be of the P-type and, in turn, that of the elements that define the drain (72) and the source (71) must be of the N-type.

Next, a first layer of conductive material (9) is deposited on the surface as seen in the plan view of Figure 5, which contacts the gate (4) and a first guard ring defined by the polarised protective trench (5) through the contact window (91) that exposes the implantation (3).

Next, a second layer of conductive material (10) is deposited that covers the cell together with all the channels (6) as seen in the elevation view of Figure 5, which contacts all the source contacts (71), through the windows of the source contacts (101) that expose the implantations, as can be seen in the OB cross section of Figure 5.

Finally, a third layer of low resistivity, electrically conductive material (721) is deposited that covers the entire surface on the lower portion thereof, on the back of the block (1) as seen in the AO and BO cross sections of Figure 5, which defines the drain contact (721) of the device.

## Claims

1. A JFET-type transistor comprising a block (1) of P- or N-type uniformly doped semiconductor material or with a highly doped epitaxial layer, the JFET-type transistor being **characterised in that** it comprises:
- a first dielectric layer (2) covering one surface of the block (1) at least partially,
- at least one series of concentric circular trenches (4) performed in the dielectric layer (2) and that reach inside the block (1) of semiconductor material, defining therebetween a series of channels (6) of semiconductor material of the block (1) wherein the internal wall of the trench (4) comprises a doped semiconductor material of the type opposite to that of the semiconductor material of the block (1) thus defining the gate (4) of the JFET-type transistor,
- at least one polarised protective trench (51) performed in the dielectric layer (2) and that reaches inside the block (1) of semiconductor material and is located outside the one or more series of concentric trenches (4),
- at least one floating protective trench (61) performed in the dielectric layer (2) and reaching inside the block (1) of semiconductor material and located outside the polarised protective trench (51),
- a second dielectric layer (8) covering the surface of the block (1) and the first dielectric layer (2) at least partially,
- a first layer of low resistivity, electrically conductive material (9) that covers the gate (5) at least partially, and contacts the gate (5) defining a gate contact (81), and with the polarised trench (61),
- a second layer of low resistivity, electrically conductive material (10) that covers the channels (6) at the upper portion thereof at least partially, defining a source contact (71), and
- a third layer of low resistivity, electrically conductive material (72) that covers the channel (6) at the lower portion thereof at least partially, defining a drain contact (721).

2. The JFET-type transistor according to claim 1, **characterised in that** the trenches (4) have a cross section of several concentric circular crowns.

3. The JFET-type transistor according to claim 1 or 2, **characterised in that** the trenches (4) have a depth smaller than the thickness of the block (1).

4. The JFET-type transistor according to any of embodiments 1 to 3, **characterised in that** the channel is made of silicon, and the trenches (41) are filled with polysilicon.

5. The JFET-type transistor according to any of embodiments 1 to 4, **characterised by** the addition of circular or polygonal polarised protective crowns around the circular crowns that form the JFET cell (4).

6. The JFET-type transistor according to any of embodiments 1 to 5, **characterised by** the addition of circular or polygonal floating protective crowns (61) around the circular crowns that form the JFET cell (4) or the polarised crowns.

7. The JFET-type transistor according to claim 1, **characterised in that** the dielectric layer (8) is made of a material that is selected from among silicon dioxide and silicon nitride.

8. A method for obtaining a JFET transistor, method **characterised in that** it comprises:
i. growing a first dielectric layer (2) on one surface of the block (1),
ii. stamping the first dielectric layer (2),
iii. doping at least one area of the surface of the block (1) through the first dielectric layer (2) with dopants (3) of the reverse type to that of the block (1),
iv. applying an annealing thermal treatment to the result of the preceding step,
v. carrying out a series of blind holes:
- in the shape of a crown on the first dielectric layer (2), which reaches an interior area of the block (1) and defines concentric trenches (4),
- with a rectangular or square shape with rounded corners, which reach an interior region of the block (1) and defines one or more polarised protective trenches (51) and one or more floating protective trenches (62) wherein the polarised protective trench (51) is located outside the trenches (4) and the floating protective trench (61) is located outside the polarised protective trench (51),
vi. carrying out a thermal process to extend the N-type dopants from the doped polysilicon towards the walls of the trenches (4), thus defining the gates (41) of the transistor,
vii. performing at least one selective etching in the first dielectric layer (2) defining a window that exposes the surface of the block (1) in the centre of each channel (6), to carry out a selective implementation of doping elements only in the regions wherein the silicon oxide has been etched, to later proceed to a thermal process, defining a source (71),
viii. carrying out a selective implementation process of doping elements on the back of the block (1) to later proceed to a thermal process defining the drain (721) of the device,
ix. depositing a second dielectric layer (8) to act as an insulating layer between conductive layers, and carrying out a selective etching of said second dielectric layer (8) in specific regions for opening windows (91,101) for contacting the gate (41) and polarised trench (51) and the source (92),
x. depositing a first conductive material layer (9), which contacts the gate (41) of the transistor,
xi selectively etching the conductive material layer (10) in specific regions to define a source contact (10) of the transistor, and
xii. depositing a third layer of low resistivity, electrically conductive material (721) that covers the channel (6) at the lower portion thereof at least partially on the back of the block (1), which contacts the drain (72) of the device and defines the drain contact (721) of the device.

9. The method according to claim 8, **characterised in that** the trench (4) has a thickness no greater than 5 microns.

10. The method according to claim 8, **characterised in that** the trench (4) has a depth of between 60 and 100 microns.

11. Use of the JFET-type transistor described in any one of claims 1 to 7 or obtainable by means of the method described in any one of claims 8 to 10 as a switch or as a current limiter.
